# EUROPÄISCHE PATENTSCHRIFT

(11) **EP 0 589 223 B1**
(45) Veröffentlichungstag und Bekanntmachung des Hinweises auf die Patenterteilung: **17.02.1999**
(21) Anmeldenummer: 93113525.5
(22) Anmeldetag: 24.08.1993
(51) Int. Cl.: G01R 31/3177, G06F 11/00, G06F 11/26

(54) **Elektronischer Baustein mit einer Schieberegisterprüfarchitektur (Boundary-Scan)**
Electronic module with a Boundary-Scan architecture
Module électronique à architecture Boundary-Scan

(30) Priorität: 25.09.1992 DE 4232271
(43) Veröffentlichungstag der Anmeldung: 30.03.1994
(73) Patentinhaber: SIEMENS AKTIENGESELLSCHAFT, 80333 München (DE)
(72) Erfinder: Bode, Hans-Jörgen Dipl.-Ing, D-81669 München (DE); Lüders, Klaus, Dipl.-Phys., D-85570 Markt Schwaben (DE)

(56) Entgegenhaltungen:
- EP-A- 0 430 844
- US-A- 5 015 875
- RESEARCH DISCLOSURE, Nr.308, Dezember 1989, NEW YORK, US Seite 954, XP000096126 'component identification data retrieval via serial interface'
- IBM TECHNICAL DISCLOSURE BULLETIN, Bd.22, Nr.12, Mai 1980 Seite 5411 'electronic serial number identification technique'
- ELEKTRONIK, Bd.38, Nr.9, 28. April 1989, MüNCHEN DE Seiten 108 - 113, XP000037010 MAIERHOFER 'Der "JTAG Boundary-Scan"'

## Beschreibung

Die Erfindung betrifft einen elektronischen Baustein mit einer Schieberegisterprüfarchitektur (Boundary-Scan).

Der hohe Komplexitätsgrad integrierter Schaltungssysteme und die erreichte Miniaturisierung im Bereich der Verbindungs-und Aufbautechniken elektronischer Baugruppen lassen konventionelle Prüfverfahren immer häufiger nur mit einem unwirtschaftlichen Aufwand realisierbar erscheinen.
Zunehmend an Bedeutung gewinnt deshalb ein Prüfverfahren, das eine in dem elektronischen Baustein integrierte Prüfeinrichtung nutzt und als "Boundary-Scan" bekannt und nach IEEE 1149.1 normiert ist.

Wesentliches Merkmal dieser Prüfeinrichtung ist ein zwischen die Bausteinanschlüsse und die Schaltungsanschlüsse des Bausteinkerns eingefügtes Schieberegister, das die serielle Einstellung und Beobachtung aller Bausteinanschlüsse ermöglicht. Über eine Schnittstelle können dieses Schieberegister auf dem Baustein gesteuert und die Schieberegister mehrerer Bausteine auf einer Baugruppe beispielsweise zu einer Ringstruktur verbunden werden. Damit lassen sich auf einer Baugruppe Testdaten ein- und ausschieben, deren Auswertung eine die einzelnen Bausteine als auch deren Verbindungsleitungen betreffende Fehlerlokalisierung ermöglicht.

Über prüftechnikspezifische Bausteinanschlüsse kann die Boundary-Scan-Prüfeinrichtung eines Bausteins entsprechend dem IEEE-Standard 1149.1 auf unterschiedliche Betriebsweisen eingestellt werden. Dies ist beispielsweise in der Veröffentlichung J.Maierhofer, B. Müller: Der "JTAG Boundary-Scan", Elektronik Nr. 9/1989, Seiten 108 bis 113 beschrieben.

In der vorgenannten Veröffentlichung ist ausgeführt, daß die Boundary-Scan-Prüfeinrichtung optional ein Herstellerregister enthalten kann. Dieses Herstellerregister ist 32 Bit weit und enthält Informationen über Herstellerdaten wie einen Identifikationscode und eine Versionsnummer. Ublicherweise wird das Herstellerregister als zusätzliches Register aufgebaut. Da das Herstellerregister optional ist und Siliziumfläche andererseits sehr teuer, enthalten in der Regel nur vergleichsweise große elektronische Bausteine, bei denen der zusätzliche Platzbedarf für das Herstellerregister nicht ins Gewicht fällt, diese Option.

Aus EP 0 430 844 A2 ist eine Anordnung bekannt, bei der das Herstellerregister in einen Prüfpfad aus Schieberegistern eingebaut ist. Der mehrere Bits umfassende Herstellercode wird über die Dateneingänge von Registerzellen, die in eine Schiebregister-Prüfzelle integriert sind, programmiert. Dabei steht allerdings der Dateneingang nicht mehr für andere Zwekke zur Verfügung.

Der Erfindung liegt daher die Aufgabe zugrunde, eine Möglichkeit zur Realisierung eines Herstellerregisters anzugeben, ohne daß zusätzlicher Platz auf dem Bausteinkern, d.h. der Nutzschaltung, benötigt wird.

Diese Aufgabe wird mit den Merkmalen des Anspruchs 1 gelöst.

Ausgestaltungen der Erfindung ergeben sich aus Unteransprüchen.

Die Erfindung wird nachfolgend anhand der Figuren der Zeichnung näher erläutert. Es zeigen:
- Figur 1: eine schematische Darstellung eines elektronischen Bausteins mit erfindungsgemäßer Boundary-Scan Prüfeinrichtung und
- Figur 2: ein Prinzipschaltbild einer erfindungsgemäßen Prüfzelle.

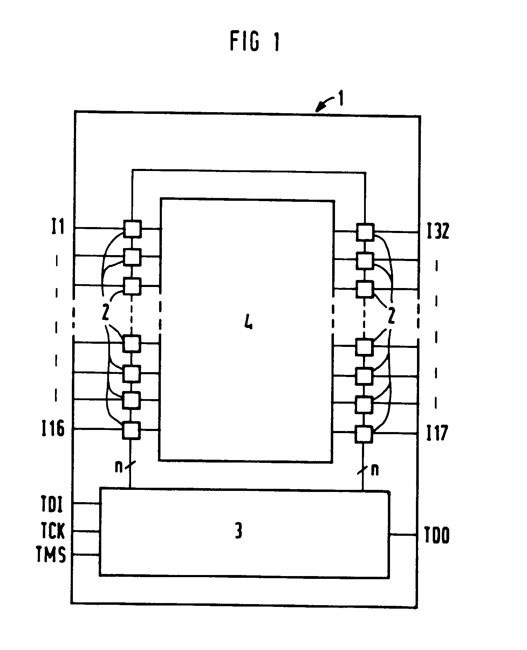

Der in Figur 1 gezeigte elektronische Baustein 1 mit einer Schieberegisterprüfarchitektur (Boundary-Scan) enthält einen Bausteinkern 4 mit der Nutzschaltung sowie eine Boundary-Scan-Prüfeinrichtung. Diese Prüfeinrichtung enthält Prüfzellen 2 und eine Ablaufsteuerung 3. Die Prüfzellen sind auf dem Baustein zwischen die Bausteinanschlüsse I1 bis I32 und den Bausteinkern 4 geschaltet. Untereinander sind die Prüfzellen über Datenleitungen n miteinander und mit der Ablaufsteuerung 3 verbunden.

Nach dem Normierungsstandard IEEE 1149.1 sind vier zusätzliche Anschlüsse sowohl auf der Baustein- als auch auf einer Baugruppenebene mit mehreren derartigen Bausteinen vorgesehen. Über einen Dateneingang TDI werden Testmuster in das Boundary-Scan eingelesen, die über den Ausgang TDO seriell ausgelesen werden können. Ein zentraler Test-Takt TCK ermöglicht die Ableitung von Taktphasen zur Synchronisation des Testablaufs. Über den Eingang TMS kann ein Prüfmodus ausgewählt werden, indem seriell Protokolldaten zur Auflaufsteuerung des Tests eingelesen werden. Die Versorgungsspannung mit den Potentialen VDD und VSS für den elektronischen Baustein wird über zwei der Anschlüsse I1 bis I32 angelegt.

Die Erfindung sieht vor, daß jede der beispielsweise aus der vorgenannten Veröffentlichung bekannten Prüfzellen (Boundary-Scan-Zellen) eine Registerzelle enthält, die mit einem Herstellerdatum programmierbar ist. In gleicher Weise, wie bekannte Prüfzellen mit Hilfe eines Multiplexers Testdaten oder Daten vom Bausteinkern bzw. von Anschlüssen des Bausteins erhalten, kann die Registerzelle mit Herstellerdaten programmiert werden. Die Programmierung erfolgt in der Weise, daß ein auf dem Baustein sowieso vorhandener Potentialwert für die Versorgungsspannung, d.h. VDD oder VSS, in einem bestimmten Betriebsmodus an die Registerzelle angelegt wird. Dies entspricht quasi einem Rücksetzen der Zelle. Aufgrund der Programmierbarkeit der Prüfzellen läßt sich demgemäß das Herstellerregister in den Boundary-Scan, also die sowieso notwendigen Prüfzellen implementieren. Zusätzlicher Platz zur Realisierung des Herstellerregisters auf dem Bausteinkern wird nicht benötigt.

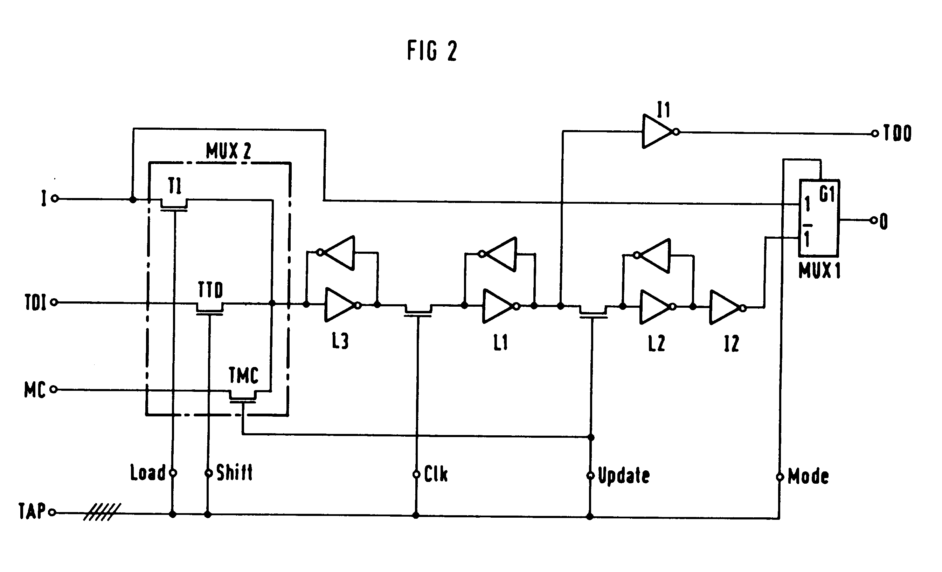

Figur 2 zeigt ein schematisches Schaltbild zur Realisierung einer erfindungsgemäßen Prüfzelle. Die Prüfzelle ist universell für eine Eingangs- oder eine Ausgangszelle einer integrierten Schaltung einsetzbar. Für eine tristatefähige Ausgangszelle werden zwei Prüfzellen benötigt. Mit dem im Signalpfad zwischen den Anschlüssen I und O liegenden Multiplexer MUX1 können im Normalbetrieb die Eingangssignale und im Testbetrieb die Testdaten des Boundary-Scan durchgeschaltet werden. I und O bilden dabei Anschlüsse des elektronischen Bausteins bzw. des Bausteinkerns. Im Normalbetrieb wirkt allein der Multiplexer MUX1 auf den Signalpfad. Im Testbetrieb, der mit Hilfe des Anschlusses Mode aus dem Bus TAP der Ablaufsteuerung eingestellt wird, werden die in der Speicherzelle L2 gespeicherten Daten über den Inverter I2 zum Ausgang O durchgeschaltet. Die Speicherzelle L2 ist dabei als Latch aus zwei gegeneinander geschalteten Invertern aufgebaut. Über einen zweiten Multiplexer MUX2 können Signale vom Bausteinkern bzw. vom Bausteinanschluß I, Testdaten über den Anschluß TDI oder über den Anschluß MC ein Herstellercode in eine Speicherzelle L3 eingelesen werden. Die Steuerung des Multiplexers erfolgt mit Signalen, die über den Busanschluß TAP von der Ablaufsteuerung geliefert werden. So steuert ein Anschluß Load über den Transistor TI den Anschluß I zur Prüfzelle L3 durch, das Signal Shift über den Transistor TTD die Testdaten am Anschluß TDI zur Speicherzelle L3 durch und ein Steuersignal Update über den Transistor TMC den Anschluß MC mit dem programmierten Herstellercode zur Speicherzelle L3 durch. In der Ablaufsteuerung ist selbstverständlich dafür gesorgt, daß sich die Steuersignale für die Transistoren TI, TTD und TMC nicht überlappen.

Der von der Speicherzelle L3 gespeicherte Wert wird mit Hilfe des Taktsignals CLK aus dem TAP-Bus der Ablaufsteuerung synchron in die Speicherzelle L1 übernommen. Der Multiplexer MUX2 und die Speicherzellen L1 und L3 bilden den Schiebepfad des Boundary-Scan. Entsprechend wird der Ausgangsanschluß der Speicherzelle L1 über den Inverter I1 an den Testdatenausgang TDO gelegt. Der Ausgang der Speicherzelle L1 wird über den vom Anschluß Update gesteuerten nicht näher bezeichneten Transistor in die Speicherzelle L2 übernommen und über den Inverter I2 an einen Datenanschluß des Multiplexers MUX1 gelegt. Gleichzeitig wird der Herstellercode in die Prüfzelle bzw. Prüfzellen übernommen, was mit dem Rücksetzen der Zellen vergleichbar ist.

Der Herstellercode, d.h. ein Rücksetzwert von VDD oder VSS, ist am Anschluß MC angelegt. Das die Rücksetzung der Registerzellen ermöglichende Steuersignal am Anschluß Update des Busses TAP der Ablaufsteuerung sorgt dann dafür, daß dieser Herstellercode in die Registerzelle bzw. die Speicherzelle L3 eingelesen wird. Da jede Prüfzelle des Boundary-Scan mit einer derartigen Registerzelle ausgestattet ist, läßt sich auf diese Weise ein Herstellerregister mit mindestens der Bitbreite der Prüfzellen implementieren, dessen Daten seriell auslesbar sind. Da die Boundary-Scan-Prüfzellen sowieso im Anschlußbereich des Bausteins Platz beanspruchen, fällt die erfindungsgemäß vorgesehene Implementierung des Herstellerregisters nicht ins Gewicht. Für den Bausteinkern des elektronischen Bausteins wird kein zusätzlicher Platz benötigt.

## Patentansprüche

1. Elektronischer Baustein mit einer Boundary-Scan-Schieberegisterprüfarchitektur, die Prüfzellen (2) enthält, wobei jede Prüfzelle einen Anschluß (I) für Daten und einen Anschluß (TDI) für Testdaten sowie eine Vielzahl von Registerzellen (L1, L2) und einen Multiplexer (MUX2) aufweist,
**dadurch gekennzeichnet, daß**
jede Prüfzelle einen zusätzlichen Anschluß (MC) für Herstellerdaten und jede Prüfzelle eine zusätzliche Registerzelle (L3) aufweist, wobei die Herstellerdaten mit dem Multiplexer (MUX2) in die zusätzliche Registerzelle (L3) einlesbar sind.

2. Baustein nach Anspruch 1,
**dadurch gekennzeichnet**
daß die Registerzelle (L3) im Schiebepfad der Prüfzelle liegt.

3. Baustein nach einem der Ansprüche 1 oder 2,
**dadurch gekennzeichnet,**
daß die Registerzelle (L3) in Serie zu einer synchron steuerbaren Speicherzelle (L1) liegt.

## Claims

1. Electronic chip comprising a boundary-scan shift register test architecture which contains test cells (2), each test cell exhibiting a terminal (I) for data and a terminal (TDI) for test data and a multiplicity of register cells (L1, L2) and a multiplexer (MUX2), characterized in that each test cell exhibits an additional terminal (MC) for manufacturer's data and each test cell exhibits an additional register cell (L3), wherein the manufacturer's data can be read into the additional register cell (L3) by means of the multiplexer (MUX2).

2. Chip according to Claim 1, characterized in that the register cell (L3) is located in the shift path of the test cell.

3. Chip according to one of Claims 1 or 2, characterized in that the register cell (L3) is located in series with a synchronously controllable memory cell (L1).

## Revendications

1. Module électronique ayant une architecture Boundary-Scan qui contient des cellules de test (2), chaque cellule de test comportant une borne (I) pour des données et une borne (TDI) pour des données de test ainsi que plusieurs cellules de registre (L1, L2) et un multiplexeur (MUX2),
caractérisé par le fait que chaque cellule de test comporte une borne supplémentaire (MC) pour des données de fabricant et chaque cellule de test comporte une cellule de registre supplémentaire (L3), les données de fabricant pouvant être écrites grâce au multiplexeur (MUX2) dans la cellule de registre supplémentaire (L3).

2. Module selon la revendication 1,
caractérisé par le fait que la cellule de registre (L3) se trouve dans la voie du signal de la cellule de test.

3. Module selon l'une des revendications 1 ou 2,
caractérisé par le fait que la cellule de registre (L3) se trouve en série avec une cellule de mémoire (L1) pouvant être commandée de manière synchrone.
